# EUROPEAN PATENT APPLICATION

(11) **EP 1 289 352 A2**
(43) Date of publication of application: **05.03.2003**
(21) Application number: 02004245.3
(22) Date of filing: 26.02.2002
(51) Int. Cl.: H05K 1/16, H01Q 1/38

(54) **High-frequency circuit device and method for manufacturing the same**

(30) Priority: 21.08.2001 JP 2001250108
(71) Applicant: Hitachi, Ltd., Chiyoda-ku, Tokyo 101-8010 (JP); Hitachi Car Engineering Co., Ltd., Hitachinaka-shi, Ibaraki 312-0062 (JP)
(72) Inventor: Isono, Tadashi, Hitachi Car Engineering Co., Ltd., Hitachi-shi, Ibaraki 312-0062 (JP); Nakazawa, Terumi, Hitachi,Ltd., Intell.Prop.Group, Chiyoda-ku, Tokyo 100-8220 (JP); Oouchi, Shirou, Hitachi,Ltd., Intell.Prop.Group, Chiyoda-ku, Tokyo 100-8220 (JP); Sasada, Yoshiyuki, Hitachi,Ltd., Intell.Prop.Group, Chiyoda-ku, Tokyo 100-8220 (JP); Ohba, Mamoru, Hitachi,Ltd., Intell.Prop.Group, Chiyoda-ku, Tokyo 100-8220 (JP)
(74) Representative: Beetz & Partner Patentanwälte

(57) **Abstract**

A high-frequency circuit device using a plane antenna is provided which has improved reliability of electrical conduction even when subjected to repeated bending stresses. A film structure of a wiring pattern is constituted by forming a Cu-film layer (6) on an organic substrate (5), and then forming a Ni-plated film (7) and an Au-plated film (8) successively on the Cu-film layer. The Ni-plated film is formed by electrolytic plating. An elongation rate of the Ni-plated film formed by electrolytic plating is 4.9 % at minimum. A thermal shock test proves that the wiring pattern is free from cracks and disconnections. Hence, reliability against repeated bending stresses can be improved.

## Description

### BACKGROUND OF THE INVENTION

### 1. Field of the Invention

The present invention relates to a high-frequency circuit device operating in high-frequency bands, such as microwaves and millimeter waves, and more particularly to a high-frequency circuit device using a plane antenna formed on an organic substrate.

### 2. Description of the Related Art

In a high-frequency circuit device operating in high-frequency bands, such as microwaves and millimeter waves, an antenna for transmitting a high-frequency signal generated from a high-frequency semiconductor device, e.g., an oscillator, is generally constituted by micro-strip lines formed on an organic substrate using the printed wiring technique.

As a film structure of micro-strip lines, there are known two types, i.e., 1) one comprising only a Cu foil, and 2) the other comprising a Cu foil and an Au-plated layer formed on the surface of the Cu foil by electroless plating of Cu-Ni-Au, the latter structure being adapted for the case of requiring Au wire bonding.

In a high-frequency circuit, however, for the purpose of suppressing a transmission loss of a high-frequency signal, it is required for a plane antenna to be formed on a substrate that is made of a material having a low dielectric constant, e.g., a fluorocarbon resin, and has a thickness as small as possible. The rigidity of the substrate is therefore very low. When a wiring pattern is formed on such a substrate as being thin and having a low rigidity, the substrate tends to easily deform over time due to changes in external environment, e.g., temperature changes, and hence the wiring pattern is subjected to repeated bending stresses.

However, when micro-strip lines have a film structure formed by electroless plating of Cu-Ni-Au as conventional, the following problem occurs. The plated film is hard to bend and is brittle because it has a low elongation rate. As a result, reliability of electrical conduction is deteriorated due to repeated bending stresses imposed on the plated film.

### SUMMARY OF THE INVENTION

Accordingly, it is an object of the present invention to provide a high-frequency circuit device using a plane antenna, which has improved reliability of electrical conduction even when subjected to repeated bending stresses.
(1) To achieve the above object, according to the present invention, there is provided a high-frequency circuit device comprising an organic substrate and a conductor formed on the organic substrate and constituted by a multilayered metal film including a Ni-plated film, wherein the Ni-plated film is formed by electrolytic plating.
   With that feature, reliability of electrical conduction is improved even when the conductor in the form of the multilayered metal film is subjected to repeated bending stresses.
(2) To achieve the above object, according to the present invention, there is also provided a high-frequency circuit device comprising an organic substrate and a conductor formed on the organic substrate and constituted by a multilayered metal film, wherein any metal film of the multilayered metal film has an elongation rate of not less than 4.9 %.
   With that feature, reliability of electrical conduction is improved even when the conductor in the form of the multilayered metal film is subjected to repeated bending stresses.
(3) To achieve the above object, according to the present invention, there is further provided a method for manufacturing a high-frequency circuit device, the method comprising a step of forming, on an organic substrate, a conductor of a multilayered metal film including a Ni-plated film, wherein the step of forming the conductor includes a step of forming the Ni-plated film by electrolytic plating.

With that method, reliability of electrical conduction is improved even when the conductor in the form of the multilayered metal film is subjected to repeated bending stresses.

### BRIEF DESCRIPTION OF THE DRAWINGS

Fig. 1 is a perspective view of an overall construction of a high-frequency circuit device according to one embodiment of the present invention;
Fig. 2 is a sectional view taken along the line A - A in Fig. 1;
Fig. 3 is a sectional view of the overall construction of the high-frequency circuit device according to one embodiment of the present invention; and
Figs. 4A to 4E show successive steps of a method for manufacturing a plane antenna used in the high-frequency circuit device according to one embodiment of the present invention.

### DESCRIPTION OF THE PREFERRED EMBODIMENTS

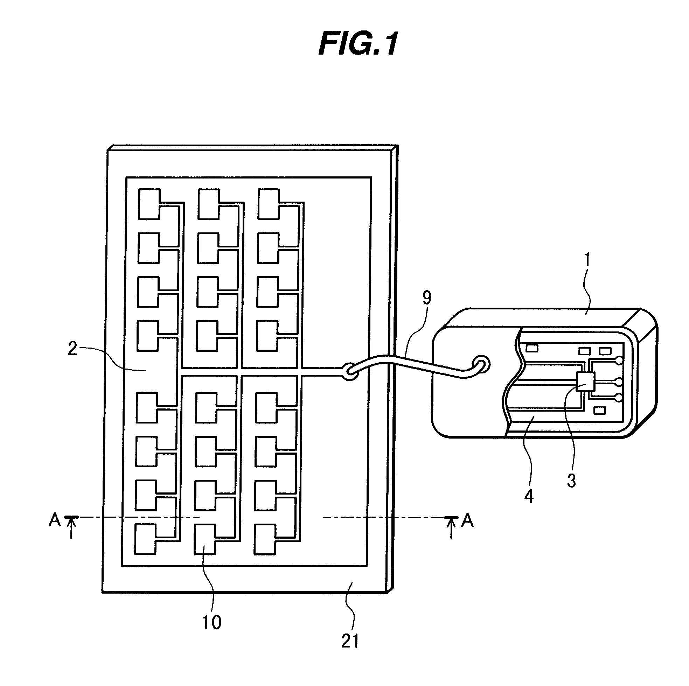

The construction of a high-frequency circuit device according to one embodiment of the present invention will be described below with reference to Figs. 1 to 3.

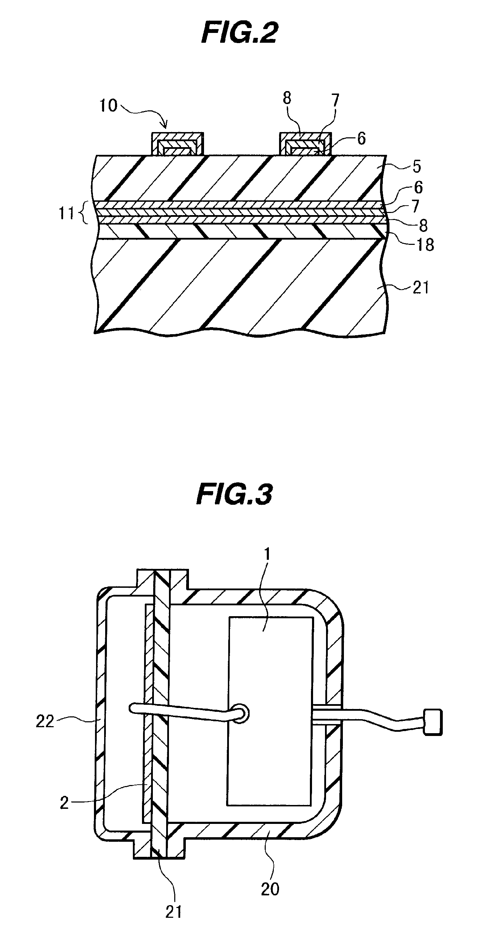

Fig. 1 is a perspective view of an overall construction of the high-frequency circuit device according to one embodiment of the present invention; Fig. 2 is a sectional view taken along the line A - A in Fig. 1; and Fig. 3 is a sectional view of the overall construction of the high-frequency circuit device according to one embodiment of the present invention. Note that the same reference numerals in Figs. 1 to 3 denote the same components.

As shown in Fig. 1, the high-frequency circuit device of this embodiment comprises a circuit module 1 and a plane antenna 2. The plane antenna 2 and the circuit module 1 are connected to each other by a coaxial line 9 for transmitting a high-frequency signal.

The circuit module 1 executes signal processing in high-frequency bands. The circuit module 1 accommodates an IC chip 3, such as an oscillator, and a high-frequency circuit board 4 including a high-frequency transmission path.

The plane antenna 2 is constituted by forming a wiring pattern 10 on an organic substrate using the printed wiring technique, the organic substrate being made of a material having a low dielectric constant, e.g., a fluorocarbon resin, and fixed to a base 21 (as described later). The base 21 may be formed of any suitable resin material such as a polyimide resin.

The sectional structure of the plane antenna 2 will now be described with reference to Fig. 2.

Cu foils are rolled over both surfaces of an organic substrate 5 to form Cu-film layers 6. When through holes penetrating the organic substrate 5 are required for electrical conduction between the Cu-film layers 6 on both sides, the through holes are Cu-plated. A wiring pattern 10 of the plane antenna 2, shown in Fig. 1, is formed by etching the Cu-film layer 6 on the front side. The patterned Cu-film layer 6 is coated with a Ni-plated film 7 and an Au-plated film 8 successively in that order. A film structure of the wiring pattern 10 is thus completed.

On the other hand, the other Cu-film layer 6, Ni-plated film 7 and Au-plated film 8 are similarly formed on the rear side of the organic substrate 5 opposed to the wiring pattern 10, whereby a ground surface 11 is formed. The ground surface 11 is fully put under the ground potential.

By forming the wiring pattern 10 and the ground surface 11 respectively on the front and rear sides of the organic substrate 5, as described above, micro-strip lines for transmitting a high-frequency signal are constituted.

The plane antenna 2 having the above-described construction is fixedly bonded to the base 21 using an adhesive 18.

The Au-plated film 8 on the wiring pattern 10 of the plane antenna 2 is intended to prevent corrosion of the Cu-film layer 6. Corrosion of the Cu-film layer 6, i.e., corrosion of the wiring pattern 10 of the plane antenna 2, immediately leads to deterioration in characteristics of a transmitting and receiving device. Therefore, the Cu-film layer 6 must be protected against corrosion.

For realizing such protection against corrosion, the Cu-film layer 6 requires to be shielded from the external environment while minimizing a loss in gain of the plane antenna 2. As a shielding method, it is conceivable to cover the plane antenna 2 with an organic material having a low dielectric constant, or to coat an organic material having a low dielectric constant directly on the Cu-film layer 6. However, shielding the Cu-film layer 6 with an organic material has a difficulty in preventing intrusion of, particularly, vaporized corrosive substances.

Unlike the method of coating an organic material, the method of coating the surface of the Cu-film layer 6 with a metal superior in corrosion, such as the Au-plated film 8, is advantageous in that there occurs neither an initial reduction in gain of the plane antenna, nor a reduction over time in gain of the plane antenna because the coated metal acts to prevent corrosion of the Cu-film layer 6. In order to prevent performance deterioration of the plane antenna caused by corrosion, therefore, it is effective to coat the Cu-film layer 6 with a plated film of a metal having superior corrosion resistance.

When coating the Au-plated film 8 on the Cu-film layer 6, the Ni-plated film 7 must be formed as an undercoat of the Au-plated film 8 for ensuring good stability and adhesion of the Au-plated film 8. As a method of forming a Ni-plated film, it has hitherto been general to employ electroless plating that is able to simplify the production process.

In contrast, this embodiment is featured in that the Ni-plated film 7 of the multilayered conductive films, which constitute the wiring pattern 10 of the plane antenna 2 (or the high-frequency circuit board 4) shown in Fig. 1, is formed by electrolytic plating (electroplating).

When repeated bending stresses are imposed on the wiring pattern 10, cracks would occur starting from one of the multilayered conductive films constituting the wiring pattern 10, which is made of a material having a minimum elongation rate. Among the Cu-film layer 6, the Ni-plated film 7 and the Au-plated film 8 constituting the wiring pattern 10 as described above, the Ni-plated film 7 is made of a material having a minimum elongation rate, and hence one of the multilayered conductive films from which cracks would start is the Ni-plated film 7. Herein, the term 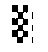 elongation rate 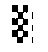 means a percentage obtained by applying a tensile stress to a material and measuring an amount by which the material is elongated from the original length until it is broken.

The following Table 1 shows, by way of example, experimental results obtained by forming Ni-plated films with the electroless plating conventionally used and the electrolytic plating used in this embodiment, and then examining respective elongation rates of the Ni-plated films and breakage of wiring patterns (similar to that denoted by 10) based on a thermal shock test.

**Table 1**

| Ni-plating method | Electroless plating | Electrolytic plating →Heat treatment | Electrolytic plating |
|---|---|---|---|
| Elongation rate (%) | 1.3 to 2.0 | 2.5 to 3.0 | 4.9 to 6.3 |
| Cracks in wiring pattern | occurred | occurred | none |
| Electrical conduction | none | conducted | conducted |

In the experiments, the thermal shock test was made over 100 cycles in which the temperature was rapidly changed between -40°C and 100°C in two hours per cycle.

For comparison with the Ni-plated film formed by the electroless plating and the Ni-plated film formed by the electrolytic plating, another sample was prepared by forming a Ni-plated film with the electrolytic plating and hardening the film with heat treatment. Results of examining cracks and electrical conduction of a wiring pattern (similar to that denoted by 10) after a thermal shock test are also listed in Table 1.

As seen from the results of Table 1, cracks and disconnections were found in the wiring pattern including the Ni-plated film, which was formed by the electroless plating and had a low elongation rate, but they were not found in the wiring pattern 10 including the Ni-plated film formed by the electrolytic plating. Thus, reliability against repeated bending stresses can be improved by employing the electrolytic plating to form a Ni-plated film and increasing the elongation rate of the Ni-plated film.

Further, as listed in Table 1, the elongation rate of the sample, which was hardened with heat treatment after the electrolytic plating, was 3.0 % at maximum. In that sample, the electrical conduction after the thermal shock test was satisfactory, but cracks occurred in the wiring pattern. It can therefore be said that the elongation rate on the order of 3 % is insufficient to achieve good reliability against the repeated bending stresses.

On the other hand, the elongation rate of the Ni-plated film of the wiring pattern 10, which was free from cracks and disconnections after the thermal shock test, was 4.9 % at minimum. Stated otherwise, reliability against the repeated bending stresses can be improved if all of the multilayered conductive films constituting the wiring pattern 10, including the Ni-plated film, has the elongation rate of not less than 4.9 %.

The overall construction of the high-frequency circuit device according to this embodiment will now be described with reference to Fig. 3. The circuit module 1 is installed in a housing 20. The plane antenna 2 is bonded to the base 21. The base 21 is fixed to the housing 20. The plane antenna 2 is covered with an antenna protection member 22.

In the high-frequency circuit device having such a construction, the wiring pattern 10 of the plane antenna 2 has a film structure including a Ni-plated film formed by electrolytic plating. Therefore, reliability against the repeated bending stresses can be improved and performance reliability of the high-frequency circuit device can also be improved.

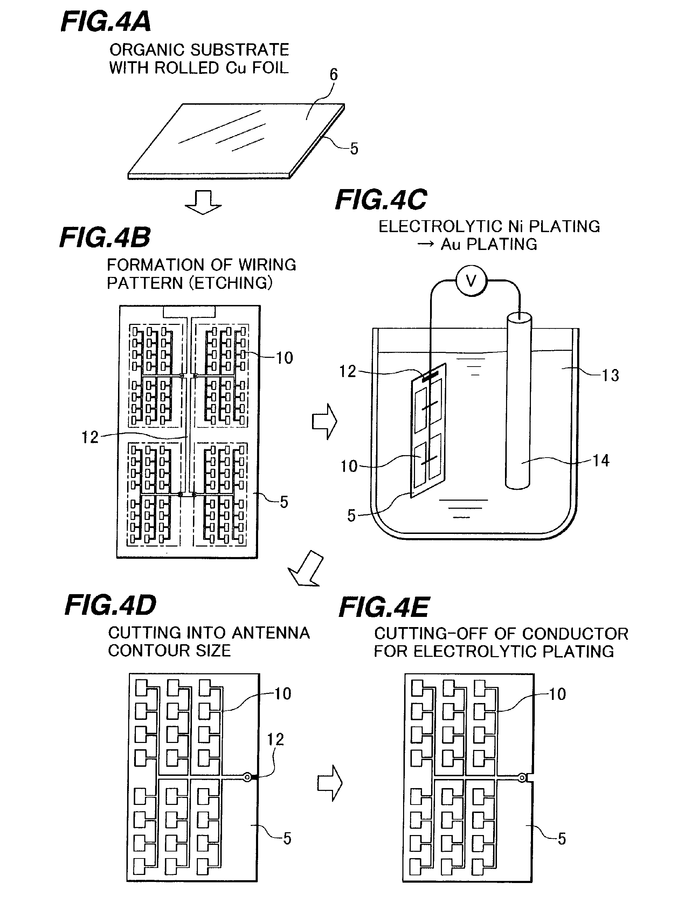

A method for manufacturing the plane antenna 2 used in the high-frequency circuit device according to this embodiment will be described below with reference to Figs. 4A to 4E.

Figs. 4A to 4E show successive steps of the method for manufacturing a plane antenna used in the high-frequency circuit device according to one embodiment of the present invention. Note that the same reference numerals in Figs. 1 to 3 denote the same components.

As shown in Fig. 4A, Cu foils are rolled over both surfaces of an organic substrate 5 to form Cu-film layers 6.

Then, as shown in Fig. 4B, the Cu-film layer 6 on one side is etched to form a wiring pattern 10 and a conductor 12 for electrolytic plating, the conductor 12 being electrically conducted to the wiring pattern 10, i.e., being continuously extended for connection to each wiring pattern 10.

Then, as shown in Fig. 4C, electroplated Ni and Au films, denoted respectively by 7, 8 in Fig. 2, are formed successively to cover the Cu-film layer 6 by using a part of the conductor 12 for electrolytic plating as an electrode, through which a voltage is to be applied for the electrolytic plating, and applying the voltage between an anode 14 and the part of the conductor 12 both immersed in an electrolytic plating bath 13.

Then, as shown in Fig. 4D, the substrate 5 is cut for division into a contour size of each plane antenna 2.

Finally, as shown in Fig. 4E, the conductor 12 for electrolytic plating is cut off.

In the plane antenna 2 thus manufactured, because the wiring pattern 10 includes no electrical disconnections, the wiring pattern is entirely put under the same potential just by applying a voltage to the conductor 12 for electrolytic plating, which is formed to extend from a part of each wiring pattern. Accordingly, the wiring pattern 10 can be coated with the Ni-plated film formed by electrolytic plating through a simple process. As a result, a highly reliable plane antenna can be obtained at a lower production cost.

With this embodiment, as described above, since the Ni-plated film 7 of the multilayered conductive films, which constitute the wiring pattern 10 of the plane antenna 2, is formed by electrolytic plating, the elongation rate of the wiring pattern 10 can be increased and hence reliability against repeated bending stresses can be improved.

As is apparent from the above description, according to the present invention, in a high-frequency circuit device using a plane antenna, reliability in electrical conduction can be improved even when the device being subjected to repeated bending stresses.

## Claims

1. A high-frequency circuit device comprising an organic substrate (5) and a conductor (10, 6-8) formed on said organic substrate and constituted by a multilayered metal film including a Ni-plated film (7),
wherein said Ni-plated film is formed by electrolytic plating.

2. A high-frequency circuit device comprising an organic substrate (5) and a conductor (10, 6-8) formed on said organic substrate and constituted by a multilayered metal film,
wherein any metal film of said multilayered metal film has an elongation rate of not less than 4.9 %.

3. A method for manufacturing a high-frequency circuit device, the method comprising a step of forming, on an organic substrate, a conductor of a multilayered metal film including a Ni-plated film,
wherein the step of forming the conductor includes a step of forming said Ni-plated film by electrolytic plating.
